(19) Europäisches Patentamt
European Patent Office
Office européen des brevets

(11) EP 3 141 918 B1

(12) EUROPEAN PATENT SPECIFICATION

(45) Date of publication and mention
of the grant of the patent:
**28.10.2020 Bulletin 2020/44**

(51) Int Cl.:
***G01R 31/08*** (2020.01)

(21) Application number: **15275199.6**

(22) Date of filing: **08.09.2015**

(54) **IMPROVEMENTS IN OR RELATING TO DETERMINING A FAULT LOCATION IN A POWER TRANSMISSION MEDIUM**

VERBESSERUNGEN AN ODER IM ZUSAMMENHANG MIT DER BESTIMMUNG EINER FEHLERSTELLE IN EINEM STROMÜBERTRAGUNGSMEDIUM

AMÉLIORATIONS APPORTÉES OU SE RAPPORTANT À LA DÉTERMINATION D'UN EMPLACEMENT DÉFECTUEUX DANS UN MILIEU DE TRANSMISSION DE PUISSANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.03.2017 Bulletin 2017/11**

(73) Proprietor: **General Electric Technology GmbH 5400 Baden (CH)**

(72) Inventors:
• **HA, Hengxu**
  **Stafford ST16 3SL (GB)**
• **SRI GOPALA KRISHNA MURTHI, Sankara Subramanian**
  **Stafford ST17 4TR (GB)**

• **YU, Lianfu**
  **Beijing (CN)**

(74) Representative: **Brevalex**
  **95, rue d'Amsterdam**
  **75378 Paris Cedex 8 (FR)**

(56) References cited:
**US-A1- 2006 097 728     US-A1- 2007 156 358**
**US-A1- 2015 081 235**

• **YANG CHENG ET AL: "Study on the Fault Location Algorithm Based on R-L Model for Transmission Lines with Single-pole Reclosure", DIANLI XITONG ZIDONGHUA - AUTOMATION OF ELECTRIC POWER SYSTEMSPRESS, vol. 34, no. 10, 25 May 2010 (2010-05-25), pages 71-75, XP055256254, CN ISSN: 1000-1026**

**Description**

This invention relates to a method of determining a fault location in a power transmission medium.

Accurate fault location is important in electrical power networks because it can help reduce operating costs by avoiding the need for expensive visual inspections of a power transmission medium, e.g. a power transmission line, as well as reduce the revenue loss caused by an extended network outage.

YANG CHENG et al: "Study on the Fault Location Algorithm Based on R-L Model for Transmission Lines with Single-pole Reclosure", Dianli Xitong Zidonghua - Automation of Electric Power Systems Press, vol. 34, no. 10, 25 May 2010, pages 71-75 ("YANG CHENG") discloses a method of determining a fault location by using an algorithm. The algorithm of YANG CHENG calculates the zero sequence source impedance at the remote end of a power transmission medium when one phase of the electrical network is cleared.

According to a first aspect of the invention there is provided a method of determining a fault location in a power transmission medium comprising the steps of:

(a) measuring one or more electrical characteristics of a power transmission medium at a local end of the power transmission medium;

(b) determining a zero sequence source impedance at a remote end of the power transmission medium based on the or each measured electrical characteristic of the power transmission medium; and

(c) calculating a position along the power transmission medium of a fault based on the determined zero sequence source impedance at the remote end of the power transmission medium so as to determine the fault location in the power transmission medium,

the method being characterised in that step (b) of determining a zero sequence source impedance at a remote end of the power transmission medium includes calculating a zero sequence source impedance at the local end of the power transmission medium using the or each measured electrical characteristic of the power transmission medium.

Determining a zero sequence source impedance at a remote end of the power transmission medium obviates the need to assume that the angle of current distribution coefficients of associated positive, negative and zero sequence currents are zero which, because the current distribution coefficients of especially the positive and negative sequence current differ from zero, is otherwise a significant source of error in determining the position of a fault.

Moreover, the zero sequence values of an electrical power network are more homogenous than the positive and negative sequence values of such a network since load impedance is not a factor in the zero sequence values, and so the zero-sequence current distribution coefficient angle is not sensitive to the zero-sequence source impedance at the remote end.

The foregoing results in a highly accurate fault location method, with errors typically being controlled to within the range +/- 2%. In addition, the method of the invention only requires measurements from one end, i.e. a local end, of the power transmission medium and so provides a single-ended fault location solution.

The phase of the zero sequence source impedance at the remote end is similar to the phase of the zero sequence source impedance at the local end, and so utilising the zero sequence source impedance at the local end to determine the zero sequence source impedance at the remote end helps to minimise any error in the determined zero sequence source impedance at the remote end.

In addition the zero sequence source impedance at the local end is readily calculable from the or each measured electrical characteristic of the power transmission medium at the local end without the need for complicated and time-consuming computation.

Optionally the zero sequence source impedance at the local end of the power transmission medium is calculated according to:

$$z_{S0} = -\frac{\dot{U}_0}{\dot{I}_0}$$

where,

$z_{S0}$ is the zero sequence source impedance at the local end of the power transmission medium;

$\dot{U}_0$ is a zero sequence voltage phasor determined at the local end of the power transmission medium; and

$\dot{I}_0$ is a zero sequence current phasor determined at the local end of the power transmission medium.

Such voltage and current phasors can be readily calculated from the measured electrical characteristics of the power transmission medium at the local end, and so provide an accurate and repeatable way of calculating the zero sequence source impedance at the local end.

In a preferred embodiment of the invention the zero sequence source impedance at the remote end is determined from the zero sequence source impedance at the local end according to

$$z_{R0} = k_{set} * z_{S0} * \frac{|z_{L0}|}{|z_{S0}|}$$

where,

$z_{R0}$ is the zero sequence source impedance at the remote end;
$k_{set}$ is a power transmission medium coefficient established according to the length of the power transmission medium between the local and remote ends;
$z_{S0}$ is the zero sequence source impedance at the local end; and
$z_{L0}$ is the zero sequence impedance of the length of power transmission medium extending between the local and remote ends.

Determining the zero sequence source impedance at the remote end from the zero sequence source impedance at the local end in the foregoing manner further helps to keep any error in the determined fault position to a minimum.

Step (c) of calculating a position along the power transmission medium of a fault based on the determined zero sequence source impedance at the remote end of the power transmission medium may include the following steps:

(i) dividing the power transmission medium into a plurality of sections;
(ii) calculating for each section a corresponding fault location value; and
(iii) determining a faulty section of power transmission medium having the lowest corresponding fault location value.

Dividing the power transmission medium into a plurality of sections avoids the method of the invention inadvertently converging to a false solution which incorrectly positions the fault beyond the power transmission medium under consideration.

Meanwhile, determining a faulty section of power transmission medium having the lowest corresponding fault location value desirably identifies which section of power transmission medium the fault is located in and thereby establishes the position of the fault along the power transmission medium with an acceptable degree of resolution, i.e. to within a given length of one section of power transmission medium.

Preferably a corresponding fault location value for each section is calculated according to

$$f(n) = \left| \mathrm{Imag}\{\dot{U}_M \bar{I}_0 e^{j\alpha(n)}\} - n\Delta x \mathrm{Imag}\{(z_1 \dot{I}_M)\bar{I}_0 e^{j\alpha(n)}\} \right|$$

where,

$$\alpha(n) = \arg \frac{(L - n\Delta x)z_0 + z_{R0}}{z_{S0} + z_{R0} + Lz_0}$$

with,

$\dot{U}_M$ being a measured voltage phasor at the local end;
$\dot{I}_M$ being a measured current phasor at the local end;
$\bar{I}_0$ being the conjugate of a zero sequence current phasor at the local end;
$n$ being the number of the section of power transmission medium for which the aforementioned calculation is being carried out;
$\Delta x$ being the length of each section of power transmission medium;
$z_1$ being a positive sequence impedance per unit length of the power transmission medium;
$z_0$ being a zero-sequence impedance per unit length of the power transmission medium;
L being the length of the power transmission medium;

$z_{S0}$ being the zero sequence source impedance at the local end; and

$z_{R0}$ is the determined zero sequence source impedance at the remote end.

Such a step desirably produces a fault location value for each section of power transmission medium which is capable of locating the fault section which has the lowest corresponding fault location value.

Optionally the method of the invention incudes after step (iii) of determining a faulty section of power transmission medium having the lowest corresponding fault location value, the further step (iv) of calculating the distance of the faulty section from the local end.

Such a step usefully provides a measurable parameter identifying the position of the fault which can be used, e.g. by maintenance personnel needing to visually inspect and/or repair the fault.

In another embodiment of the invention step (c) of calculating a position along the power transmission medium of a fault based on the determined zero sequence source impedance at the remote end of the power transmission medium includes the following steps:

(i) establishing an initial zero sequence current distribution coefficient;
(ii) calculating an initial fault distance value based on the initial zero sequence current distribution coefficient;
(iii) using the initial fault distance value to establish a subsequent zero sequence current distribution coefficient; and
(iv) calculating a subsequent fault distance value based on the subsequent zero sequence current distribution coefficient.

Such steps desirably calculate the position along the power transmission medium of a fault with a reduced hardware and computational overhead since it is not necessary to carry out multiple calculations for different sections of the power transmission medium.

Preferably step (c) of calculating a position along the power transmission medium of a fault based on the determined zero sequence source impedance at the remote end of the power transmission medium includes the further steps of:

(v) using the subsequent fault distance value to establish a further subsequent zero sequence current distribution coefficient;
(vi) calculating a further subsequent fault distance value based on the further subsequent zero sequence current distribution coefficient; and
(vii) repeating steps (v) and (vi) until the deviation between consecutive calculated subsequent fault distance values falls below a predetermined accuracy threshold.

Repeating steps (v) and (vi) in the aforementioned manner desirably results in locating the position of a fault with a degree of accuracy that can be tailored according to the overall configuration of the electrical power network in which the power transmission medium is located.

Optionally the fault distance value is calculated according to:

$$x = \frac{\text{Imag}\{\dot{U}_M \bar{I}_0 e^{j\alpha}\}}{\text{Imag}\{(z_1 \dot{I}_M)\bar{I}_0 e^{j\alpha}\}}$$

where,

x is the calculated fault distance value;
$\dot{U}_M$ is a measured voltage phasor at the local end;
$\dot{I}_M$ is a measured current phasor at the local end;
$\bar{I}_0$ is the conjugate of a zero sequence current phasor at the local end; and
$z_1$ is a positive sequence impedance per unit length of the power transmission medium.

The fault distance value may be used to establish a zero sequence current distribution coefficient according to:

$$\alpha = \arg \frac{(L-x)z_0 + z_{R0}}{z_{S0} + z_{R0} + Lz_0}$$

where,

$\alpha$ is the angle of the established zero sequence current distribution coefficient;
$z_1$ is a positive sequence impedance per unit length of the power transmission medium;
$z_0$ is a zero-sequence impedance per unit length of the power transmission medium;
$L$ is the length of the power transmission medium;
$z_{S0}$ is the zero sequence source impedance at the local end; and
$z_{R0}$ is the determined zero sequence source impedance at the remote end.

Such steps advantageously permit an iterative process which allows the accuracy of the fault location to be honed to a desired extent.

When the power transmission medium is one of a plurality of power transmission mediums within a multi-phase electrical power network each of which said power transmission medium corresponds to a respective phase of the multi-phase electrical power network, the method of the invention may additionally include determining which single phase or group of phases is faulty.

Identifying the faulty phase or group of phases assists subsequently in correctly calculating a corresponding fault location value for respective sections of the power transmission medium, and thereafter correctly calculating the position along the power transmission medium of the fault.

According to a second aspect of the invention there is provided a fault locator for determining a fault location in a power transmission medium, the fault locator including a programmable control unit configured to:

(a) measure one or more electrical characteristics of a power transmission medium at a local end of the power transmission medium;
(b) determine a zero sequence source impedance at a remote end of the power transmission medium based on the or each measured electrical characteristic of the power transmission medium; and
(c) calculate a position along the power transmission medium of a fault based on the determined zero sequence source impedance at the remote end of the power transmission medium so as to determine the fault location in the power transmission medium,

the fault locator being characterised in that the programmable control unit being configured to determine a zero sequence source impedance at a remote end of the power transmission medium includes the programmable control unit being configured to calculate a zero sequence source impedance at the local end of the power transmission medium using the or each measured electrical characteristic of the power transmission medium.

The fault locator of the invention shares the benefits of the corresponding steps of the method of the invention.

There now follows a brief description of preferred embodiments of the invention, by way of non-limiting example, with reference being made to the following figures in which:

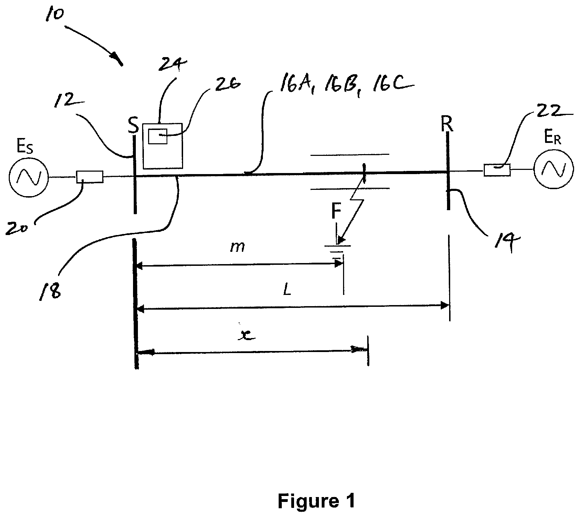

Figure 1 shows a schematic view of an example multi-phase electrical power network to which a method of the invention can be applied to determine a fault location therein.

An example multi-phase electrical power network is designated generally by reference numeral 10 and is shown schematically in Figure 1. More particularly the example multiphase network 10 is a three-phase network which includes phases A, B and C, although other example multi-phase power networks may include fewer than or more than three phases.

The electrical power network 10 includes first and second terminals 12, 14 that are interconnected by three power transmission mediums 16A, 16B, 16C (only one of which is shown in Figure 1). Each power transmission medium 16A, 16B, 16C has a length L and corresponds to a phase A, B, C of the electrical power network 10. In the example shown each power transmission medium 16A, 16B, 16C is an overhead transmission line 18, although in other arrangements of electrical power network (not shown) one or more of the transmission mediums 16A, 16B, 16C may be an underground transmission cable.

In the electrical power network 10 shown the first terminal 12 is located at a local end S of the respective power transmission mediums 16A, 16B, 16C and the second terminal 14 is located at a remote end R of the power transmission mediums 16A, 16B, 16C, although this may be reversed in other example electrical power networks.

The first terminal 12 couples a local end voltage source $E_S$ and an associated local end source impedance 20 to each of the power transmission mediums 16A, 16B, 16C, while the second terminal 14 couples a remote end voltage source $E_R$ and an associated remote end source impedance 22 to each of the power transmission mediums 16A, 16B, 16C.

A fault locator 24 is arranged towards the local end S and in operative communication with the first terminal 12 and a protection device (not shown) that is associated with the first terminal 12.

The fault locator 24 includes a programmable control unit 26 which may, for example, take the form of a programmable microcontroller. The control unit 26 is configured to carry out a method of determining a fault location F in one or more of the power transmission mediums 16A, 16B, 16C in the example electrical power network 10 according to a first embodiment of the invention.

The first method of the invention includes the principal steps of:

(a) measuring a plurality of electrical characteristics of each power transmission medium 16A, 16B, 16C at the local end S of each of the power transmission mediums 16A, 16B 16C;

(b) determining a zero sequence source impedance $z_{R0}$ at the remote end R of the power transmission mediums 16A, 16B 16C based on the measured electrical characteristics of each respective power transmission medium 16A, 16B 16C; and

(c) calculating a position along a given power transmission medium 16A, 16B 16C of a fault based on the determined zero sequence source impedance $z_{RO}$ at the remote end R of the power transmission mediums 16A, 16B 16C so as to determine the fault location F in the said given power transmission medium 16A, 16B 16C.

Step (a) of measuring a plurality of electrical characteristics of each power transmission medium 16A, 16B, 16C at the local end S of each of the power transmission mediums 16A, 16B 16C, includes obtaining measured voltage samples $u_A(k)$, $u_B(k)$, $u_C(k)$ and measured current samples $i_A(k)$, $i_B(k)$, $i_C(k)$ at the local end S for each power transmission medium 16A, 16B, 16C, i.e. each phase A, B, C of the three-phase electrical power network 10.

In addition, respective power transmission medium 16A, 16B, 16C parameters such as a positive sequence impedance per unit length $z_1$, a zero-sequence impedance per unit length $z_0$ and the length L (all of which are available from an operator of transmission mediums 16A, 16B, 16C) are provided to the control unit 26.

The control unit 26 then establishes a zero sequence compensation coefficient $K_L$ for the power transmission mediums 16A, 16B, 16C which is calculated according to:

$$K_L = \frac{z_0 - z_1}{3z_1}$$

where,

$z_1$ is the aforementioned positive sequence impedance per unit length of a given power transmission medium 16A, 16B, 16C; and

$z_0$ is the aforementioned zero-sequence impedance per unit length of a given power transmission medium 16A, 16B, 16C.

In the meantime step (b) of determining a zero sequence source impedance $z_{R0}$ at the remote end R of the power transmission mediums 16A, 16B 16C based on the measured electrical characteristics of each respective power transmission medium 16A, 16B 16C, includes calculating a zero sequence source impedance $z_{S0}$ at the local end S of the power transmission mediums 16A, 16B, 16C using the measured electrical characteristics, i.e. the measured voltage and current samples $u_A(k)$, $u_B(k)$, $u_C(k)$, $i_A(k)$, $i_B(k)$, $i_C(k)$ at the local end S, of each power transmission medium 16A, 16B, 16C .

More particularly the zero sequence source impedance $z_{S0}$ at the local end S of the power transmission mediums 16A, 16B, 16C is calculated according to:

$$z_{S0} = -\frac{\dot{U}_0}{\dot{I}_0}$$

where,

$\dot{U}_0$ is a zero sequence voltage phasor that is determined at the local end S of the power transmission mediums 16A, 16B, 16C; and

$\dot{I}_0$ is a zero sequence current phasor that is determined at the local end S of the power transmission mediums 16A, 16B, 16C.

With respect to the example electrical power network 10 shown in Figure 1, i.e. a three-phase electrical power network 10, the zero sequence voltage phasor $\dot{U}_0$ at the local end S is given by a sum of respective voltage phasors $\dot{U}_A$, $\dot{U}_B$, $\dot{U}_C$ for each phase A, B, C and the zero sequence current phasor $\dot{I}_0$ at the local end S is given by a sum of respective current phasors $\dot{I}_A$, $\dot{I}_B$, $\dot{I}_C$ for each phase A, B, C, such that the zero sequence source impedance zso at the local end S of the power transmission mediums 16A, 16B, 16C is given by:

$$z_{S0} = -\frac{\dot{U}_0}{\dot{I}_0} = -\frac{\dot{U}_A + \dot{U}_B + \dot{U}_C}{\dot{I}_A + \dot{I}_B + \dot{I}_C}$$

With respect to other electrical power network arrangements, and further embodiments of the method of the invention for determining a fault location within such other electrical power networks, one or both of the zero sequence voltage phasor $\dot{U}_0$ at the local end S and the zero sequence current phasor $\dot{I}_0$ at the local end S may be determined differently, e.g. according to the number of phases in the other electrical power network.

Meanwhile, in the embodiment method described herein, each respective voltage phasor $\dot{U}_A$, $\dot{U}_B$, $\dot{U}_C$ and current phasor $\dot{I}_A$, $\dot{I}_B$, $\dot{I}_C$ for each phase A, B, C is calculated using a full-cycle Fourier method according to

$$X(n) = \frac{2}{N} \sum_{k=1}^{N} x(n-k+1) * \exp(j\frac{2\pi k}{N})$$

where,

$x(n)$ represents samples of corresponding voltage and current $u_A(k)$, $u_B(k)$, $u_C(k)$, $i_A(k)$, $i_B(k)$, $i_C(k)$ measured as part of step (a); and
$N$ is the number of samples per cycle.

In other embodiments of the method of the invention a different way of calculating each voltage phasor $\dot{U}_A$, $\dot{U}_B$, $\dot{U}_C$ and current phasor $\dot{I}_A$, $\dot{I}_B$, $\dot{I}_C$ may be used.

Thereafter, once the zero sequence source impedance $z_{S0}$ at the local end S of the power transmission mediums 16A, 16B, 16C has been calculated, the zero sequence source impedance $z_{R0}$ at the remote end R is determined from the zero sequence source impedance $z_{S0}$ at the local end S according to

$$z_{R0} = k_{set} * z_{S0} * \frac{|z_{L0}|}{|z_{S0}|}$$

where,

$z_{R0}$ is the zero sequence source impedance at the remote end R;
$k_{set}$ is a power transmission medium coefficient established according to the length L of the power transmission mediums 16A, 16B, 16C between the local and remote ends S, R;
$z_{S0}$ is the zero sequence source impedance at the local end S; and
$z_{L0}$ is the zero sequence impedance of the length L of power transmission mediums 16A, 16B, 16C extending between the local and remote ends S, R.

The power transmission medium coefficient $k_{set}$ is set according to the following lengths L of each power transmission medium 16A, 16B, 16C:

| L (km) | $k_{set}$ |
|---|---|
| <=50 | 0.5 |
| >50 & <=100 | 0.4 |
| >100 & <=150 | 0.3 |

(continued)

| L (km) | $k_{set}$ |
|---|---|
| >150 & <=200 | 0.2 |
| >200 | 0.1 |

Since the method of the invention is applied to a multi-phase, i.e. three phase, electrical power network 10 it is necessary additionally to carry out the step of determining which single phase A, B, C or group of phases A, B, C is faulty.

Such a step of determining which single phase A, B, C or group of phases A, B, C is faulty includes:

(i) calculating the root mean square value $\Delta I_{AB}$, $\Delta I_{BC}$, $\Delta I_{CA}$ of respective pairs of phases A, B, C;
(ii) establishing maximum and minimum root mean square values $I_{max}$, $I_{min}$; and
(iii) comparing each calculated root mean square value $\Delta I_{AB}$, $\Delta I_{BC}$, $\Delta I_{CA}$ with the established maximum and minimum root mean square values $I_{max}$, $I_{min}$.

More particularly, calculating the root mean square value $\Delta I_{AB}$, $\Delta I_{BC}$, $\Delta I_{CA}$ of respective pairs of phases A, B, C includes calculating the root mean square value of phase to phase currents according to the following individual applications of a half-cycle Fourier method:

$$\Delta I_{AB} = \frac{\omega_0}{2} \sum_{n=k}^{n=k-N/2} \left| [i_A(n) - i_B(n)] - [i_A(n-N) - i_B(n-N)] \right|;$$

$$\Delta I_{BC} = \frac{\omega_0}{2} \sum_{n=k}^{n=k-N/2} \left| [i_B(n) - i_C(n)] - [i_B(n-N) - i_C(n-N)] \right|;$$

and

$$\Delta I_{CA} = \frac{\omega_0}{2} \sum_{n=k}^{n=k-N/2} \left| [i_C(n) - i_A(n)] - [i_C(n-N) - i_A(n-N)] \right|$$

where,

$i_A$, $i_B$, $i_C$ are the samples of current at the local end S measured as part of step (a);
$n$ is the sample number; and
$N$ is the number of samples per cycle.

Thereafter, maximum and minimum root mean square values $I_{max}$, $I_{min}$ are obtained according to:

$$I_{max} = \max\{ \Delta I_{AB}, \Delta I_{BC}, \Delta I_{CA}\};$$

and

$$I_{min} = \min\{ \Delta I_{AB}, \Delta I_{BC}, \Delta I_{CA}\}$$

Each calculated root mean square value $\Delta I_{AB}$, $\Delta I_{BC}$, $\Delta I_{CA}$ is then compared with the established maximum and minimum root mean square values $I_{max}$, $I_{min}$ in the following manner so as to determine which single phase A, B, C or group of phases A, B, C is faulty, i.e.

Firstly, if

$$\frac{I_{min}}{I_{max}} < 0.1;$$

then,

$I_{min} == \Delta I_{BC}$ is indicative of phase A being faulty such that there is a fault between the corresponding power transmission medium 16A and ground;

$I_{min} == \Delta I_{CA}$ is indicative of phase B being faulty such that there is a fault between the corresponding power transmission medium 16B and ground; and

$I_{min} == \Delta I_{AB}$ is indicative of phase C being faulty such that there is a fault between the corresponding power transmission medium 16C and ground.

Secondly, if

$$\frac{I_{min}}{I_{max}} \geq 0.1$$

then,

$I_{max} == \Delta I_{BC}$ is indicative of phases B and C being faulty such that there is a combined fault between the corresponding power transmission mediums 16B, 16C and ground;

$I_{max} == \Delta I_{CA}$ is indicative of phases C and A being faulty such that there is a combined fault between the corresponding power transmission mediums 16C, 16A and ground; and

$I_{max} == \Delta I_{AB}$ is indicative of phases A and B being faulty such that there is a combined fault between the corresponding power transmission mediums 16A, 16B and ground.

Once the faulty phase A, B, C or group of phases A, B, C has been determined, step (c) of calculating a position along a given power transmission medium 16A, 16B 16C of a fault, includes:

(i) dividing the corresponding faulty power transmission medium 16A, 16B, 16C into a plurality of sections;

(ii) calculating for each section a corresponding fault location value; and

(iii) determining a faulty section of the corresponding power transmission medium 16A, 16B, 16C having the lowest corresponding fault location value.

The number of sections that the corresponding faulty power transmission medium (or mediums) 16A, 16B, 16C is divided into is established by considering the capability of the protection device associated with the first terminal 12 at the local end S, as well as the desired level of accuracy in terms of identifying where the fault is located.

In the method of the invention described herein, and bearing in mind the approximate 50km length L of the power transmission mediums 16A, 16B, 16C in the example electrical power network 10 to which it is applied, the corresponding fault power transmission medium 16A, 16B, 16C is divided into 200 sections. In other embodiments of the invention, however, the number of sections may be more than or less than 200.

In the meantime, a corresponding fault location value for each section is calculated according to

$$f(n) = \left| \mathrm{Imag}\{\dot{U}_M \bar{I}_0 e^{j\alpha(n)}\} - n\Delta x \mathrm{Imag}\{(z_1 \dot{I}_M)\bar{I}_0 e^{j\alpha(n)}\} \right|$$

where,

$$\alpha(n) = \arg \frac{(L - n\Delta x)z_0 + z_{R0}}{z_{S0} + z_{R0} + Lz_0}$$

with,

$\dot{U}_M$ being a measured voltage phasor at the local end S;

$\dot{I}_M$ being a measured current phasor at the local end S;

$\overline{I}_0$ being the conjugate of a zero sequence current phasor at the local end S;

n being the number of the section of the corresponding faulty power transmission medium 16A, 16B, 16C for which the aforementioned calculation is being carried out;

$\Delta x$ being the length of each section of the corresponding faulty power transmission medium 16A, 16B, 16C;

$z_1$ being the positive sequence impedance per unit length of the corresponding faulty power transmission medium 16A, 16B, 16C;

$z_0$ being the zero-sequence impedance per unit length of the corresponding faulty power transmission medium 16A, 16B, 16C;

$L$ being the length of the corresponding faulty power transmission medium 16A, 16B, 16C;

$z_{S0}$ being the zero sequence source impedance at the local end; and

$z_{R0}$ is the determined zero sequence source impedance at the remote end.

Meanwhile Imag{} means taking the imaginary part of the complex number inside {}.

In the meantime each of the measured voltage phasor $\dot{U}_M$ at the local end S and the measured current phasor $\dot{I}_M$ at the local end S is established according to which phase A, B, C or group of phases A, B, C is determined to be faulty.

More particularly, if

- phase A is determined to be faulty then:

$$\dot{U}_M = \dot{U}_A;$$

and

$$\dot{I}_M = \dot{I}_A + K_L * 3\dot{I}_0$$

- phase B is determined to be faulty then:

$$\dot{U}_M = \dot{U}_B;$$

and

$$\dot{I}_M = \dot{I}_B + K_L * 3\dot{I}_0$$

- phase C is determined to be faulty then:

$$\dot{U}_M = \dot{U}_C;$$

and

$$\dot{I}_M = \dot{I}_C + K_L * 3\dot{I}_0$$

- phases A and B are determined to be faulty then:

$$\dot{U}_M = \dot{U}_A - \dot{U}_B;$$

and

$$\dot{I}_M = \dot{I}_A - \dot{I}_B$$

- phases B and C are determined to be faulty then:

$$\dot{U}_M = \dot{U}_B - \dot{U}_C;$$

and

$$\dot{I}_M = \dot{I}_B - \dot{I}_C;$$

and

- phases C and A are determined to be faulty then:

$$\dot{U}_M = \dot{U}_C - \dot{U}_A;$$

and

$$\dot{I}_M = \dot{I}_C - \dot{I}_A$$

The zero sequence current phasor $\dot{I}_0$ at the local end S is calculated using a full-cycle Fourier method in a similar manner to that set out above in connection with the respective voltage and current phasors $\dot{U}_A$, $\dot{U}_B$, $\dot{U}_C$, $\dot{I}_A$, $\dot{I}_B$, $\dot{I}_C$ for each phase A, B, C.

It follows that determining a faulty section of the corresponding power transmission medium 16A, 16B, 16C, i.e. the section which has the lowest corresponding fault location value, determines the fault location in the corresponding power transmission medium 16A, 16B, 16C with an effective resolution equivalent to the length $\Delta x$ of each section of power transmission medium 16A, 16B, 16C.

The method of the invention may, optionally, include after step (iii) above of determining a faulty section of power transmission medium having the lowest corresponding fault location value and thereby determining the fault location, the further step (iv) of calculating the distance $m$ of the faulty section from the local end S.

Such a distance $m$ of the faulty section from the local end S may be calculated according to the following:

$$m = N_m \Delta x$$

where,

$N_m$ is the number of the faulty section of the corresponding power transmission medium 16A, 16B, 16C; and
$\Delta x$ is the length of each section of the corresponding faulty power transmission medium 16A, 16B, 16C.

In a second embodiment of the invention, step (c) of calculating a position along the power transmission medium of a fault based on the determined zero sequence source impedance at the remote end of the power transmission medium, includes the following steps:

(i) establishing an initial zero sequence current distribution coefficient;
(ii) calculating an initial fault distance value based on the initial zero sequence current distribution coefficient;
(iii) using the initial fault distance value to establish a subsequent zero sequence current distribution coefficient; and
(iv) calculating a subsequent fault distance value based on the subsequent zero sequence current distribution coefficient.

The initial zero sequence current distribution coefficient is, by way of example, set at zero although this need not necessarily be the case.

In any event, in the second embodiment of the invention step (c) includes the further steps of:

(v) using the subsequent fault distance value to establish a further subsequent zero sequence current distribution coefficient;

(vi) calculating a further subsequent fault distance value based on the further subsequent zero sequence current distribution coefficient; and

(vii) repeating steps (v) and (vi) until the deviation between consecutive calculated subsequent fault distance values falls below a predetermined accuracy threshold.

The predetermined accuracy threshold is, in the second embodiment of the invention, given by

$$\left| x^{(k)} - x^{(k-1)} \right| < \varepsilon .$$

where

$x^{(k)}$ is the kth x;
$x^{(k-1)}$ is the (k-1)th x; and
$\varepsilon$ is normally set as 0.01.

Other values may, however be used, as well as entirely different accuracy thresholds.

The fault distance value is calculated according to:

$$x = \frac{\mathrm{Imag}\{\dot{U}_M \bar{I}_0 e^{j\alpha}\}}{\mathrm{Imag}\{(z_1 \dot{I}_M) \bar{I}_0 e^{j\alpha}\}}$$

where,

$x$ is the calculated fault distance value, i.e. the calculated distance of the fault from the local end S of the corresponding power transmission medium 16A, 16B, 16C, as shown in Figure 1;
$\dot{U}_M$ is a measured voltage phasor at the local end;
$\dot{I}_M$ is a measured current phasor at the local end;
$I_0$ is the conjugate of a zero sequence current phasor at the local end; and
$z_1$ is a positive sequence impedance per unit length of the power transmission medium.

Meanwhile the fault distance value is used to establish a zero sequence current distribution coefficient according to:

$$\alpha = \arg \frac{(L-x)z_0 + z_{R0}}{z_{S0} + z_{R0} + Lz_0}$$

where,

$\alpha$ is the angle of the established zero sequence current distribution coefficient;
$z_1$ is a positive sequence impedance per unit length of the power transmission medium;
$z_0$ is a zero-sequence impedance per unit length of the power transmission medium;
$L$ is the length of the power transmission medium;
$z_{S0}$ is the zero sequence source impedance at the local end; and
$z_{R0}$ is the determined zero sequence source impedance at the remote end.

Accordingly the fault location is determined by repeatedly calculating subsequent fault distance values x in order to establish the distance, i.e. x, of the fault from the local end S of the corresponding power transmission medium 16A, 16B, 16C.

**Claims**

1. A method of determining a fault location (F) in a power transmission medium (16A, 16B, 16C) comprising the steps of:

(a) measuring one or more electrical characteristics of a power transmission medium (16A, 16B, 16C) at a local end (S) of the power transmission medium (16A, 16B, 16C);

(b) determining a zero sequence source impedance ($z_{RO}$) at a remote end (R) of the power transmission medium (16A, 16B, 16C) based on the or each measured electrical characteristic of the power transmission medium (16A, 16B, 16C); and

(c) calculating a position along the power transmission medium (16A, 16B, 16C) of a fault based on the determined zero sequence source impedance ($z_{RO}$) at the remote end (R) of the power transmission medium (16A, 16B, 16C) so as to determine the fault location (F) in the power transmission medium (16A, 16B, 16C),

the method being **characterised in that** step (b) of determining a zero sequence source impedance at a remote end (R) of the power transmission medium (16A, 16B, 16C) includes calculating a zero sequence source impedance ($z_{RO}$) at the local end (S) of the power transmission medium (16A, 16B, 16C) using the or each measured electrical characteristic of the power transmission medium (16A, 16B, 16C).

2. A method of determining a fault location (F) in a power transmission medium (16A, 16B, 16C) according to Claim 1 wherein the zero sequence source impedance ($z_{RO}$) at the local end (S) of the power transmission medium (16A, 16B, 16C) is calculated according to:

$$z_{S0} = -\frac{\dot{U}_0}{\dot{I}_0}$$

where,

$z_{S0}$ is the zero sequence source impedance at the local end of the power transmission medium;
$\dot{U}_0$ is a zero sequence voltage phasor determined at the local end of the power transmission medium; and
$\dot{I}_0$ is a zero sequence current phasor determined at the local end of the power transmission medium.

3. A method of determining a fault location (F) in a power transmission medium (16A, 16B, 16C) according to Claim 1 or Claim 2 wherein the zero sequence source impedance ($z_{RO}$) at the remote end (R) is determined from the zero sequence source impedance ($z_{RO}$) at the local end (S) according to

$$z_{R0} = k_{set} * z_{S0} * \frac{\left|z_{L0}\right|}{\left|z_{S0}\right|}$$

where,

$z_{R0}$ is the zero sequence source impedance at the remote end;
$k_{set}$ is a power transmission medium coefficient established according to the length of the power transmission medium between the local and remote ends;
$z_{S0}$ is the zero sequence source impedance at the local end; and
$z_{L0}$ is the zero sequence impedance of the length of power transmission medium extending between the local and remote ends.

4. A method of determining a fault location (F) in a power transmission medium (16A, 16B, 16C) according to any preceding claim wherein step (c) of calculating a position along the power transmission medium (16A, 16B, 16C) of a fault based on the determined zero sequence source impedance ($z_{RO}$) at the remote end (R) of the power transmission medium (16A, 16B, 16C) includes the following steps:

(i) dividing the power transmission medium (16A, 16B, 16C) into a plurality of sections;
(ii) calculating for each section a corresponding fault location value; and
(iii) determining a faulty section of power transmission medium (16A, 16B, 16C) having the lowest corresponding fault location value.

5. A method of determining a fault location (F) in a power transmission medium (16A, 16B, 16C) according to Claim 4 wherein a corresponding fault location value for each section is calculated according to

$$f(n) = \left| \mathrm{Imag}\{\dot{U}_M \bar{I}_0 e^{j\alpha(n)}\} - n\Delta x \mathrm{Imag}\{(z_1 \dot{I}_M)\bar{I}_0 e^{j\alpha(n)}\} \right|$$

where,

$$\alpha(n) = \arg \frac{(L - n\Delta x)z_0 + z_{R0}}{z_{S0} + z_{R0} + Lz_0}$$

with,

$\dot{U}_M$ being a measured voltage phasor at the local end;
$\dot{I}_M$ being a measured current phasor at the local end;
$\bar{I}_0$ being a conjugate of a zero sequence current phasor at the local end;
$n$ being the number of the section of power transmission medium for which the aforementioned calculation is being carried out;
$\Delta x$ being the length of each section of power transmission medium;
$z_1$ being a positive sequence impedance per unit length of the power transmission medium;
$z_0$ being a zero-sequence impedance per unit length of the power transmission medium;
$L$ being the length of the power transmission medium;
$z_{S0}$ being the zero sequence source impedance at the local end; and
$z_{R0}$ is the determined zero sequence source impedance at the remote end.

6. A method of determining a fault location (F) in a power transmission medium (16A, 16B, 16C) according to Claim 4 or Claim 5 including after step (iii) of determining a faulty section of power transmission medium (16A, 16B, 16C) having the lowest corresponding fault location value, the further step (iv) of calculating the distance of the faulty section from the local end (S).

7. A method of determining a fault location (F) in power transmission medium (16A, 16B, 16C) according to any of Claims 1 to 3 wherein step (c) of calculating a position along the power transmission medium (16A, 16B, 16C) of a fault based on the determined zero sequence source impedance ($z_{RO}$) at the remote end (R) of the power transmission medium (16A, 16B, 16C) includes the following steps:

(i) establishing an initial zero sequence current distribution coefficient;
(ii) calculating an initial fault distance value based on the initial zero sequence current distribution coefficient;
(iii) using the initial fault distance value to establish a subsequent zero sequence current distribution coefficient; and
(iv) calculating a subsequent fault distance value based on the subsequent zero sequence current distribution coefficient.

8. A method of determining a fault location (F) in a power transmission medium (16A, 16B, 16C) according to Claim 7 including the further steps of:

(v) using the subsequent fault distance value to establish a further subsequent zero sequence current distribution coefficient;
(vi) calculating a further subsequent fault distance value based on the further subsequent zero sequence current distribution coefficient; and
(vii) repeating steps (v) and (vi) until the deviation between consecutive calculated subsequent fault distance values falls below a predetermined accuracy threshold.

9. A method of determining a fault location (F) in a power transmission medium (16A, 16B, 16C) according to Claim 7 or Claim 8 wherein the fault distance value is calculated according to:

$$x = \frac{\mathrm{Imag}\{\dot{U}_M \bar{I}_0 e^{j\alpha}\}}{\mathrm{Imag}\{(z_1 \dot{I}_M)\bar{I}_0 e^{j\alpha}\}}$$

where,

x is the calculated fault distance value;

$\dot{U}_M$ is a measured voltage phasor at the local end;

$\dot{I}_M$ is a measured current phasor at the local end;

$\overline{I_0}$ is the conjugate of a zero sequence current phasor at the local end; and

$z_1$ is a positive sequence impedance per unit length of the power transmission medium.

10. A method of determining a fault location (F) in a power transmission medium (16A, 16B, 16C) according to any of Claims 7 to 9 wherein the fault distance value is used to establish a zero sequence current distribution coefficient according to:

$$\alpha = \arg \frac{(L-x)z_0 + z_{R0}}{z_{S0} + z_{R0} + Lz_0}$$

where,

$\alpha$ is the angle of the established zero sequence current distribution coefficient;

$z_1$ is a positive sequence impedance per unit length of the power transmission medium;

$z_0$ is a zero-sequence impedance per unit length of the power transmission medium;

$L$ is the length of the power transmission medium;

$z_{S0}$ is the zero sequence source impedance at the local end; and

$z_{R0}$ is the determined zero sequence source impedance at the remote end.

11. A method of determining a fault location (F) in a power transmission medium (16A, 16B, 16C) according to any preceding claim, wherein the power transmission medium (16A, 16B, 16C) is one of a plurality of power transmission mediums (16A, 16B, 16C) within a multi-phase electrical power network (10) each of which said power transmission medium (16A, 16B, 16C) corresponds to a respective phase (A, B, C) of the multi-phase electrical power network (10), and wherein the method additionally includes determining which single phase or group of phases is faulty.

12. A fault locator (24) for determining a fault location (F) in a power transmission medium (16A, 16B, 16C), the fault locator (24) including a programmable control unit (26) configured to:

(a) measure one or more electrical characteristics of a power transmission medium (16A, 16B, 16C) at a local end (S) of the power transmission medium (16A, 16B, 16C);

(b) determine a zero sequence source impedance ($z_{RO}$) at a remote end (R) of the power transmission medium (16A, 16B, 16C) based on the or each measured electrical characteristic of the power transmission medium (16A, 16B, 16C); and

(c) calculate a position along the power transmission medium (16A, 16B, 16C) of a fault based on the determined zero sequence source impedance ($z_{RO}$) at the remote end (R) of the power transmission medium so as to determine the fault location (F) in the power transmission medium (16A, 16B, 16C),

the fault locator (24) being **characterised in that** the programmable control unit (26) being configured to determine a zero sequence source impedance ($z_{RO}$) at a remote end (R) of the power transmission medium (16A, 16B, 16C) includes the programmable control unit (24) being configured to calculate a zero sequence source impedance ($z_{RO}$) at the local end (S) of the power transmission medium (16A, 16B, 16C) using the or each measured electrical characteristic of the power transmission medium (16A, 16B, 16C).

**Patentansprüche**

1. Verfahren zum Bestimmen eines Störungsortes (F) in einem Stromübertragungsmedium (16A, 16B, 16C), umfassend die Schritte von:

(a) Messen einer oder mehrerer elektrischer Charakteristiken eines Stromübertragungsmediums (16A, 16B, 16C) an einem lokalen Ende (S) des Stromübertragungsmediums (16A, 16B, 16C);

(b) Bestimmen einer Nullsequenz-Quellenimpedanz ($z_{RO}$) an einem entfernten Ende (R) des Stromübertragungsmediums (16A, 16B, 16C) auf der Grundlage der oder jeder gemessenen elektrischen Charakteristik des Stromübertragungsmediums (16A, 16B, 16C); und

(c) Berechnen einer Position entlang des Stromübertragungsmediums (16A, 16B, 16C) einer Störung auf der Grundlage der ermittelten Nullsequenz-Quellenimpedanz ($z_{RO}$) am entfernten Ende (R) des Stromübertragungsmediums (16A, 16B, 16C), um den Störungsort (F) im Stromübertragungsmedium (16A, 16B, 16C) zu bestimmen,

wobei das Verfahren **dadurch gekennzeichnet ist, dass** der Schritt (b) des Bestimmens einer Nullsequenz-Quellenimpedanz an einem entfernten Ende (R) des Stromübertragungsmediums (16A, 16B, 16C) das Berechnen einer Nullsequenz-Quellenimpedanz ($z_{RO}$) am lokalen Ende (S) des Stromübertragungsmediums (16A, 16B, 16C) unter Verwendung der oder jeder gemessenen elektrischen Charakteristik des Stromübertragungsmediums (16A, 16B, 16C) umfasst.

2. Verfahren zum Bestimmen eines Störungsortes (F) in einem Stromübertragungsmedium (16A, 16B, 16C) nach Anspruch 1, wobei die Nullsequenz-Quellenimpedanz ($z_{RO}$) am lokalen Ende (S) des Stromübertragungsmediums (16A, 16B, 16C) berechnet wird nach:

$$z_{S0} = \frac{\dot{U}_0}{\dot{I}_0}$$

wobei

$z_{S0}$ die Nullsequenz-Quellenimpedanz am lokalen Ende des Stromübertragungsmediums ist;
$\dot{U}_0$ ein Nullsequenz-Spannungsphasor ist, der am lokalen Ende des Stromübertragungsmediums bestimmt wird; und
$\dot{I}_0$ ein Nullsequenz-Stromphasor ist, der am lokalen Ende des Stromübertragungsmediums bestimmt wird.

3. Verfahren zum Bestimmen eines Störungsortes (F) in einem Stromübertragungsmedium (16A, 16B, 16C) nach Anspruch 1 oder Anspruch 2, wobei die Nullsequenz-Quellenimpedanz ($z_{RO}$) am entfernten Ende (R) aus der Nullsequenz-Quellenimpedanz ($z_{RO}$) am lokalen Ende (S) bestimmt wird nach

$$z_{R0} = k_{set} * z_{S0} * \frac{|z_{L0}|}{|z_{S0}|}$$

wobei

$z_{R0}$ die Nullsequenz-Quellenimpedanz am entfernten Ende ist;
$k_{set}$ ein Stromübertragungsmedium-Koeffizient ist, der nach der Länge des Stromübertragungsmediums zwischen dem lokalen und dem entfernten Ende ermittelt wird;
$z_{S0}$ die Nullsequenz-Quellenimpedanz am lokalen Ende ist; und
$z_{L0}$ die Nullsequenz-Impedanz der Länge des Stromübertragungsmediums ist, die sich zwischen dem lokalen und dem entfernten Ende erstreckt.

4. Verfahren zum Bestimmen eines Störungsortes (F) in einem Stromübertragungsmedium (16A, 16B, 16C) nach einem der vorstehenden Ansprüche, wobei der Schritt (c) des Berechnens einer Position entlang des Stromübertragungsmediums (16A, 16B, 16C) einer Störung auf der Grundlage der bestimmten Nullsequenz-Quellenimpedanz ($z_{RO}$) am entfernten Ende (R) des Stromübertragungsmediums (16A, 16B, 16C) die folgenden Schritte umfasst:

(i) Unterteilen des Stromübertragungsmediums (16A, 16B, 16C) in eine Vielzahl von Abschnitten;
(ii) Berechnen, für jeden Abschnitt, eines entsprechenden Störungsortwertes; und
(iii) Bestimmen eines gestörten Abschnitts des Stromübertragungsmediums (16A, 16B, 16C) mit dem niedrigsten entsprechenden Störungsortwert.

5. Verfahren zum Bestimmen eines Störungsortes (F) in einem Stromübertragungsmedium (16A, 16B, 16C) nach Anspruch 4, wobei ein entsprechender Störungsortwert für jeden Abschnitt berechnet wird gemäß

$$f(n)=\left|\text{Imag}\left\{\dot{U}_M\bar{I}_0e^{j\alpha(n)}\right\}-n\Delta x\text{Imag}\left\{(z_1\dot{I}_M)\bar{I}_0e^{j\alpha(n)}\right\}\right|$$

wobei

$$\alpha(n)=arg\frac{(L-n\Delta x)z_0+z_{R0}}{z_{S0}+z_{R0}+Lz_0}$$

wobei

$\dot{U}_M$ ein gemessener Spannungsphasor am lokalen Ende ist;

$\dot{I}_M$ ein gemessener Stromphasor am lokalen Ende ist;

$\bar{I}_0$ ein Konjugat eines Nullsequenz-Stromphasors am lokalen Ende ist;

$n$ die Nummer des Abschnitts des Stromübertragungsmediums ist, für den die vorgenannte Berechnung durchgeführt wird;

$\Delta x$ die Länge jedes Abschnitts des Stromübertragungsmediums ist;

$z_1$ eine positive Sequenzimpedanz pro Längeneinheit des Stromübertragungsmediums ist;

$z_0$ eine Nullsequenzimpedanz pro Längeneinheit des Stromübertragungsmediums ist;

$L$ die Länge des Stromübertragungsmediums ist;

$z_{S0}$ die Nullsequenz-Quellenimpedanz am lokalen Ende ist; und

$z_{R0}$ die bestimmte Nullsequenz-Quellenimpedanz am entfernten Ende ist.

6. Verfahren zum Bestimmen eines Störungsortes (F) in einem Stromübertragungsmedium (16A, 16B, 16C) nach Anspruch 4 oder Anspruch 5, umfassend nach Schritt (iii) des Bestimmens eines gestörten Abschnitts des Stromübertragungsmediums (16A, 16B, 16C) mit dem niedrigsten entsprechenden Störungsortwert, den weiteren Schritt (iv) des Berechnens der Entfernung des gestörten Abschnitts von dem lokalen Ende (S).

7. Verfahren zum Bestimmen eines Störungsortes (F) in einem Stromübertragungsmedium (16A, 16B, 16C) nach den Ansprüchen 1 bis 3, wobei der Schritt (c) des Berechnens einer Position entlang des Stromübertragungsmediums (16A, 16B, 16C) einer Störung auf der Grundlage der bestimmten Nullsequenz-Quellenimpedanz ($z_{R0}$) am entfernten Ende (R) des Stromübertragungsmediums (16A, 16B, 16C) die folgenden Schritte umfasst:

(i) Ermitteln eines anfänglichen Nullsequenz-Stromverteilungskoeffizienten;

(ii) Berechnen eines anfänglichen Störungsentfernungswertes auf der Grundlage des anfänglichen Nullsequenz-Stromverteilungskoeffizienten;

(iii) Verwenden des anfänglichen Störungsentfernungswertes zum Ermitteln eines nachfolgenden Nullsequenz-Stromverteilungskoeffizienten; und

(iv) Berechnen eines nachfolgenden Störungsentfernungswertes auf der Grundlage des nachfolgenden Nullsequenz-Stromverteilungskoeffizienten.

8. Verfahren zum Bestimmen eines Störungsortes (F) in einem Stromübertragungsmedium (16A, 16B, 16C) nach Anspruch 7, weiter einschließlich der Schritte von:

(v) Verwenden des nachfolgenden Störungsentfernungswertes zum Ermitteln eines weiteren nachfolgenden Nullsequenz-Stromverteilungskoeffizienten;

(vi) Berechnen eines weiteren nachfolgenden Störungsentfernungswertes auf der Grundlage des weiteren nachfolgenden Nullsequenz-Stromverteilungskoeffizienten; und

(vii) Wiederholen der Schritte (v) und (vi), bis die Abweichung zwischen aufeinanderfolgenden berechneten nachfolgenden Störungsentfernungswerten unter eine vorbestimmte Genauigkeitsschwelle fällt.

9. Verfahren zum Bestimmen eines Störungsortes (F) in einem Stromübertragungsmedium (16A, 16B, 16C) nach Anspruch 7 oder 8, wobei der Störungsentfernungswert berechnet wird nach:

$$x = \frac{\mathrm{Imag}\{\dot{U}_M \bar{I}_0 e^{j\alpha}\}}{\mathrm{Imag}\left\{(z_1 \dot{I}_M) \bar{I}_0 e^{j\alpha}\right\}}$$

wobei

x der berechnete Störungsentfernungswert ist;

$\dot{U}_M$ ein gemessener Spannungsphasor am lokalen Ende ist;

$\dot{I}_M$ ein gemessener Stromphasor am lokalen Ende ist;

$\bar{I}_0$ das Konjugat eines Nullsequenz-Stromphasors am lokalen Ende ist; und

$z_1$ eine positive Sequenzimpedanz pro Längeneinheit des Stromübertragungsmediums ist.

10. Verfahren zum Bestimmen eines Störungsortes (F) in einem Stromübertragungsmedium (16A, 16B, 16C) nach einem der Ansprüche 7 bis 9, wobei der Störungsentfernungswert verwendet wird, um einen Nullsequenz-Strom-verteilungskoeffizienten zu ermitteln nach:

$$\alpha = \arg \frac{(L-x)z_0 + z_{R0}}{z_{S0} + z_{R0} + Lz_0}$$

wobei

$\alpha$ der Winkel des ermittelten Nullsequenz-Stromverteilungskoeffizienten ist;

$z_1$ eine positive Sequenzimpedanz pro Längeneinheit des Stromübertragungsmediums ist;

$z_0$ eine Nullsequenzimpedanz pro Längeneinheit des Stromübertragungsmediums ist;

$L$ die Länge des Stromübertragungsmediums ist;

$z_{S0}$ die Nullsequenz-Quellenimpedanz am lokalen Ende ist; und

$z_{R0}$ die bestimmte Nullsequenz-Quellenimpedanz am entfernten Ende ist.

11. Verfahren zum Bestimmen eines Störungsortes (F) in einem Stromübertragungsmedium (16A, 16B, 16C) nach einem der vorstehenden Ansprüche, wobei das Stromübertragungsmedium (16A, 16B, 16C) eines aus einer Vielzahl von Stromübertragungsmedien (16A, 16B, 16C) innerhalb eines mehrphasigen elektrischen Stromversorgungsnetzes (10) ist, wovon jedes der Stromübertragungsmedien (16A, 16B, 16C) einer jeweiligen Phase (A, B, C) des mehrphasigen elektrischen Stromversorgungsnetzes (10) entspricht, und wobei das Verfahren zusätzlich das Bestimmen einschließt, welche einzelne Phase oder Gruppe von Phasen gestört ist.

12. Störungsdiagnosesystem (24) zum Bestimmen eines Störungsortes (F) in einem Stromübertragungsmedium (16A, 16B, 16C), wobei das Störungsdiagnosesystem (24) eine programmierbare Steuereinheit (26) einschließt, die konfiguriert ist, um:

(a) eine oder mehrere elektrische Charakteristiken eines Stromübertragungsmediums (16A, 16B, 16C) an einem lokalen Ende (S) des Stromübertragungsmediums (16A, 16B, 16C) zu messen;

(b) eine Nullsequenz-Quellenimpedanz ($z_{R0}$) an einem entfernten Ende (R) des Stromübertragungsmediums (16A, 16B, 16C) auf der Grundlage der oder jeder gemessenen elektrischen Charakteristik des Stromübertragungsmediums (16A, 16B, 16C) zu bestimmen; und

(c) eine Position entlang des Stromübertragungsmediums (16A, 16B, 16C) einer Störung auf der Grundlage der ermittelten Nullsequenz-Quellenimpedanz ($z_{R0}$) am entfernten Ende (R) des Stromübertragungsmediums (16A, 16B, 16C) zu berechnen, um den Störungsort (F) im Stromübertragungsmedium (16A, 16B, 16C) zu bestimmen,

wobei das Störungsdiagnosesystem (24) **dadurch gekennzeichnet ist, dass** die programmierbare Steuereinheit (26) konfiguriert ist, um eine Nullsequenz-Quellenimpedanz ($z_{R0}$) an einem entfernten Ende (R) des Stromübertragungsmediums (16A, 16B, 16C) zu bestimmen, wobei die programmierbare Steuereinheit (24) konfiguriert ist, um eine Nullsequenz-Quellenimpedanz ($z_{R0}$) am lokalen Ende (S) des Stromübertragungsmediums (16A, 16B, 16C) unter Verwendung der oder jeder gemessenen elektrischen Charakteristik des Stromübertragungsmediums (16A, 16B, 16C) zu berechnen.

**Revendications**

1. Procédé de détermination d'un emplacement défectueux (F) dans un milieu de transmission d'énergie (16A, 16B, 16C) comprenant les étapes suivantes :

   (a) la mesure d'une ou de plusieurs caractéristiques électriques d'un milieu de transmission d'énergie (16A, 16B, 16C) à une extrémité locale (S) du milieu de transmission d'énergie (16A, 16B, 16C) ;
   (b) la détermination d'une impédance de source homopolaire ($z_{RO}$) à une extrémité distante (R) du milieu de transmission d'énergie (16A, 16B, 16C) sur la base de la ou de chaque caractéristique électrique mesurée du milieu de transmission d'énergie (16A, 16B, 16C) ; et
   (c) le calcul d'une position le long du milieu de transmission d'énergie (16A, 16B, 16C) d'un défaut sur la base de l'impédance de source homopolaire ($z_{RO}$) déterminée à l'extrémité distante (R) du milieu de transmission d'énergie (16A, 16B, 16C) de manière à déterminer l'emplacement défectueux (F) dans le milieu de transmission d'énergie (16A, 16B, 16C),

   le procédé étant **caractérisé en ce que** l'étape (b) de détermination d'une impédance de source homopolaire à une extrémité distante (R) du milieu de transmission d'énergie (16A, 16B, 16C) inclut le calcul d'une impédance de source homopolaire ($z_{RO}$) à l'extrémité locale (S) du milieu de transmission d'énergie (16A, 16B, 16C) en utilisant la ou chaque caractéristique électrique mesurée du milieu de transmission d'énergie (16A, 16B, 16C).

2. Procédé de détermination d'un emplacement défectueux (F) dans un milieu de transmission d'énergie (16A, 16B, 16C) selon la revendication 1, dans lequel l'impédance de source homopolaire ($z_{RO}$) à l'extrémité locale (S) du milieu de transmission d'énergie (16A, 16B, 16C) est calculée selon :

$$z_{S0} = -\frac{\dot{U}_0}{\dot{I}_0}$$

où,

   $Z_{S0}$ est l'impédance de source homopolaire à l'extrémité locale du milieu de transmission d'énergie ;
   $\dot{U}_0$ est un phaseur de tension homopolaire déterminé à l'extrémité locale du milieu de transmission d'énergie ; et
   $\dot{I}_0$ est un phaseur de courant homopolaire déterminé à l'extrémité locale du milieu de transmission d'énergie.

3. Procédé de détermination d'un emplacement défectueux (F) dans un milieu de transmission d'énergie (16A, 16B, 16C) selon la revendication 1 ou la revendication 2 dans lequel l'impédance de source homopolaire ($z_{RO}$) à l'extrémité distante (R) est déterminée à partir de l'impédance de source homopolaire ($z_{RO}$) à l'extrémité locale (S) selon

$$z_{R0} = k_{set} * z_{S0} * \frac{|z_{L0}|}{|z_{S0}|}$$

où,

   $z_{R0}$ est l'impédance de source homopolaire à l'extrémité distante ;
   $k_{set}$ est un coefficient de milieu de transmission d'énergie établi en fonction de la longueur du milieu de transmission d'énergie entre les extrémités locale et distante ;
   $Z_{S0}$ est l'impédance de source homopolaire à l'extrémité locale ; et
   $Z_{L0}$ est l'impédance homopolaire de la longueur du milieu de transmission d'énergie s'étendant entre les extrémités locale et distante.

4. Procédé de détermination d'un emplacement défectueux (F) dans un milieu de transmission d'énergie (16A, 16B, 16C) selon une quelconque revendication précédente dans lequel l'étape (c) de calcul d'une position le long du milieu de transmission d'énergie (16A, 16B, 16C) d'un défaut sur la base de l'impédance de source homopolaire ($z_{RO}$) déterminée à l'extrémité distante (R) du milieu de transmission d'énergie (16A, 16B, 16C) inclut les étapes suivantes :

(i) la division du milieu de transmission d'énergie (16A, 16B, 16C) en une pluralité de sections ;
(ii) le calcul pour chaque section d'une valeur d'emplacement défectueux correspondante ; et
(iii) la détermination d'une section défectueuse de milieu de transmission d'énergie (16A, 16B, 16C) présentant la valeur d'emplacement défectueux correspondante la plus basse.

5. Procédé de détermination d'un emplacement défectueux (F) dans un milieu de transmission d'énergie (16A, 16B, 16C) selon la revendication 4 dans lequel une valeur d'emplacement défectueux correspondante pour chaque section est calculée selon

$$f(n) = \left| \mathrm{Imag}\{\dot{U}_M \bar{I}_0 e^{j\alpha(n)}\} - n\Delta x \mathrm{Imag}\{(z_1 \dot{I}_M)\bar{I}_0 e^{j\alpha(n)}\} \right|$$

où,

$$\alpha(n) = \arg \frac{(L - n\Delta x)z_0 + z_{R0}}{z_{S0} + z_{R0} + Lz_0}$$

avec,

$\dot{U}_M$ étant un phaseur de tension mesuré à l'extrémité locale ;
$\dot{I}_M$ étant un phaseur de courant mesuré à l'extrémité locale ;
$\bar{I}_0$ étant un conjugué d'un phaseur de courant homopolaire à l'extrémité locale ;
n étant le numéro de la section de milieu de transmission d'énergie pour laquelle le calcul susmentionné est effectué ;
$\Delta x$ étant la longueur de chaque section de milieu de transmission d'énergie ;
$z_1$ étant une impédance directe par unité de longueur du milieu de transmission d'énergie ;
$z_0$ étant une impédance homopolaire par unité de longueur du milieu de transmission d'énergie ;
L étant la longueur du milieu de transmission d'énergie ;
$z_{S0}$ étant l'impédance de source homopolaire à l'extrémité locale ; et
$z_{R0}$ est l'impédance de source homopolaire déterminée à l'extrémité distante.

6. Procédé de détermination d'un emplacement défectueux (F) dans un milieu de transmission d'énergie (16A, 16B, 16C) selon la revendication 4 ou la revendication 5 incluant après l'étape (iii) de détermination d'une section défectueuse de milieu de transmission d'énergie (16A, 16B, 16C) présentant la valeur d'emplacement défectueux correspondante la plus basse, l'étape (iv) supplémentaire de calcul de la distance de la section défectueuse par rapport à l'extrémité locale (S).

7. Procédé de détermination d'un emplacement défectueux (F) dans un milieu de transmission d'énergie (16A, 16B, 16C) selon l'une quelconque des revendications 1 à 3 dans lequel l'étape (c) de calcul d'une position le long du milieu de transmission d'énergie (16A, 16B, 16C) d'un défaut sur la base de l'impédance de source homopolaire ($z_{RO}$) déterminée à l'extrémité distante (R) du milieu de transmission d'énergie (16A, 16B, 16C) inclut les étapes suivantes :

(i) l'établissement d'un coefficient de distribution de courant homopolaire initial ;
(ii) le calcul d'une valeur de distance de défaut initiale sur la base du coefficient de distribution de courant homopolaire initial ;
(iii) l'utilisation de la valeur de distance de défaut initiale pour établir un coefficient de distribution de courant homopolaire subséquent ; et
(iv) le calcul d'une valeur de distance de défaut subséquente sur la base du coefficient de distribution de courant homopolaire subséquent.

8. Procédé de détermination d'un emplacement défectueux (F) dans un milieu de transmission d'énergie (16A, 16B, 16C) selon la revendication 7 incluant les étapes supplémentaires suivantes :

(v) l'utilisation de la valeur de distance de défaut subséquente pour établir un coefficient de distribution de courant homopolaire subséquent supplémentaire ;

(vi) le calcul d'une valeur de distance de défaut subséquente supplémentaire sur la base du coefficient de distribution de courant homopolaire subséquent supplémentaire ; et

(vii) la répétition des étapes (v) et (vi) jusqu'à ce que l'écart entre des valeurs de distance de défaut subséquentes calculées consécutives tombe en dessous d'un seuil de précision prédéterminé.

9. Procédé de détermination d'un emplacement défectueux (F) dans un milieu de transmission d'énergie (16A, 16B, 16C) selon la revendication 7 ou la revendication 8 dans lequel la valeur de distance de défaut est calculée selon :

$$x = \frac{\mathrm{Imag}\{\dot{U}_M \bar{I}_0 e^{j\alpha}\}}{\mathrm{Imag}\{(z_1 \dot{I}_M)\bar{I}_0 e^{j\alpha}\}}$$

où,

x est la valeur de distance de défaut calculée ;
$\dot{U}_M$ est un phaseur de tension mesuré à l'extrémité locale ;
$\dot{I}_M$ est un phaseur de courant mesuré à l'extrémité locale ;
$\bar{I}_0$ est le conjugué d'un phaseur de courant homopolaire à l'extrémité locale ; et
$z_1$ est une impédance directe par unité de longueur du milieu de transmission d'énergie.

10. Procédé de détermination d'un emplacement défectueux (F) dans un milieu de transmission d'énergie (16A, 16B, 16C) selon l'une quelconque des revendications 7 à 9 dans lequel la valeur de distance de défaut est utilisée pour établir un coefficient de distribution de courant homopolaire selon :

$$\alpha = \arg \frac{(L-x)z_0 + z_{R0}}{z_{S0} + z_{R0} + Lz_0}$$

où,

$\alpha$ est l'angle du coefficient de distribution de courant homopolaire établi ;
$z_1$ est une impédance directe par unité de longueur du milieu de transmission d'énergie ;
$z_0$ est une impédance homopolaire par unité de longueur du milieu de transmission d'énergie ;
$L$ est la longueur du milieu de transmission d'énergie ;
$z_{S0}$ est l'impédance de source homopolaire à l'extrémité locale ; et
$z_{R0}$ est l'impédance de source homopolaire déterminée à l'extrémité distante.

11. Procédé de détermination d'un emplacement défectueux (F) dans un milieu de transmission d'énergie (16A, 16B, 16C) selon une quelconque revendication précédente, dans lequel le milieu de transmission d'énergie (16A, 16B, 16C) est l'un d'une pluralité de milieux de transmission d'énergie (16A, 16B, 16C) au sein d'un réseau électrique à plusieurs phases (10), chacun desdits milieux de transmission d'énergie (16A, 16B, 16C) correspondant à un phase respective (A, B, C) du réseau électrique à plusieurs phases (10), et dans lequel le procédé inclut en outre la détermination de la phase individuelle ou du groupe de phases qui est défectueux.

12. Localisateur de défaut (24) pour déterminer un emplacement défectueux (F) dans un milieu de transmission d'énergie (16A, 16B, 16C), le localisateur de défaut (24) incluant une unité de commande programmable (26) configurée pour :

(a) mesurer une ou plusieurs caractéristiques électriques d'un milieu de transmission d'énergie (16A, 16B, 16C) à une extrémité locale (S) du milieu de transmission d'énergie (16A, 16B, 16C) ;

(b) déterminer une impédance de source homopolaire ($z_{RO}$) à une extrémité distante (R) du milieu de transmission d'énergie (16A, 16B, 16C) sur la base de la ou de chaque caractéristique électrique mesurée du milieu de transmission d'énergie (16A, 16B, 16C) ; et

(c) calculer une position le long du milieu de transmission d'énergie (16A, 16B, 16C) d'un défaut sur la base de l'impédance de source homopolaire ($z_{RO}$) déterminée à l'extrémité distante (R) du milieu de transmission d'énergie de manière à déterminer l'emplacement défectueux (F) dans le milieu de transmission d'énergie (16A, 16B, 16C),

le localisateur de défaut (24) étant **caractérisé en ce que** l'unité de commande programmable (26) qui est configurée pour déterminer une impédance de source homopolaire ($z_{RO}$) à une extrémité distante (R) du milieu de transmission d'énergie (16A, 16B, 16C) inclut l'unité de commande programmable (24) qui est configurée pour calculer une impédance de source homopolaire ($z_{RO}$) à l'extrémité locale (S) du milieu de transmission d'énergie (16A, 16B, 16C) en utilisant la ou chaque caractéristique électrique mesurée du milieu de transmission d'énergie (16A, 16B, 16C).

**Figure 1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YANG CHENG et al.** Study on the Fault Location Algorithm Based on R-L Model for Transmission Lines with Single-pole Reclosure. *Dianli Xitong Zidonghua - Automation of Electric Power Systems Press,* 25 May 2010, vol. 34 (10), 71-75